# EUROPEAN PATENT APPLICATION

(11) **EP 4 819 199 A1**
(43) Date of publication of application: **07.10.2026**
(21) Application number: 25167726.6
(22) Date of filing: 01.04.2025
(51) Int. Cl.: H01L 21/3065, H01L 21/308

(54) **A PATTERNING METHOD APPLICABLE IN SEMICONDUCTOR PROCESSING**

(71) Applicant: Imec VZW, 3001 Leuven (BE)
(72) Inventor: Lazzarino, Frederic, 1320 Hamme-Mille (BE); Liu, Ru-Gun, 302 Hsinchu County (TW)
(74) Representative: Patent Department IMEC

(57) **Abstract**

A target layer (25) that needs to be patterned is formed on a support substrate (26). An etch stop layer (27) and a first mask layer (28) are produced in that order on the target layer. According to embodiments of the invention, the first mask layer is patterned into a regular 2-dimensional array of openings (30). In a first directional etching step, the openings in the first mask layer are enlarged to thereby form a pattern of parallel first trenches (31) in the first mask layer (28). A second mask layer (32) is produced, possibly after thinning the patterned first mask layer. The second mask layer is patterned into the same regular array of openings (30) and thereafter the second mask layer is subjected to a second directional etching step, which enlarges the openings in the second mask layer to thereby form second parallel trenches (33) extending in a direction that crosses the direction of the first trenches,. The second directional etching also removes exposed portions of the first mask layer (28), so that the latter is eventually patterned into a pattern of pillars (34). After stripping the second mask layer (32) relative to said pillars, the pattern of pillars is transferred to the target layer (25).

## Description

### Field of the Invention

The present invention is related to semiconductor fabrication processes, in particular to patterning methods applicable in said processes.

### State of the art.

Semiconductor fabrication processing relies on advanced lithography and etch technologies capable of realizing patterns at the nanometre-sized scale required in the front-end-of-line and at the deepest levels of the back-end-of-line process sequences. Nevertheless, even the most advanced EUV lithography tools are limited in terms of the obtainable resolution, requiring expensive multiple exposure methods for printing features smaller than the resolution limit.

Producing an array of pillar-shaped features at subresolution pitch is particularly challenging using traditional single or multiple exposure lithography tools.

### Summary of the invention

The invention is related to methods in accordance with the appended claims. A target layer that needs to be patterned is formed on a support substrate. An etch stop layer and a first mask layer are produced in that order on the target layer. According to embodiments of the invention, the first mask layer is patterned into a regular 2-dimensional array of openings. A regular array is an array wherein the openings have the same in-plane dimensions and are ordered according to a repetitive pattern. This may be a square or rectangular pattern wherein the openings are arranged in perpendicular rows and columns. It is also possible to arrange the openings in rows and columns which are at an angle different from 90°. This is typically done by patterning a resist layer and transferring the resist pattern to the first mask layer, wherein said transfer may involve thinning of the first mask layer and/or removing one or more upper sublayers of the first mask layer when the latter is a multilayer stack. In a first directional etching step, the openings in the first mask layer are enlarged to thereby form a pattern of parallel first trenches in the first mask layer. The trench pattern may be transferred to the etch stop layer at this point, or this transfer can be done later in the process. A second mask layer is produced, possibly after thinning the patterned first mask layer. The second mask layer is patterned into the same regular array of openings and thereafter the second mask layer is subjected to a second directional etching step, which enlarges the openings in the second mask layer to thereby form second parallel trenches extending in a direction that crosses the direction of the first trenches. The second directional etching also removes portions of the (possibly thinned) first mask layer exposed to etch species applied in the second directional etching step, so that the latter is eventually patterned into a pattern of pillars. After stripping the second mask layer relative to said pillars, the pattern of pillars is transferred to the target layer.

When the above sequence is performed using the same rectangular array of openings for patterning both the first and the second mask layers, it is advantageous to perform the directional etching steps in mutually crossing directions which are lying in between the orthogonal directions of the rows and columns of the rectangular pattern. By applying such directional etch directions, for example at 45° and 135° relative to said column and row directions, the pitch of the resulting array of pillars is smaller than the pitch of the openings in the array. The fabrication of pillar arrays at subresolution pitch are thereby enabled, using only a single lithographic mask.

Another useful application is obtained by applying a rectangular array of openings, but wherein selected openings are omitted, i.e. openings are etched in the respective mask layers prior to the respective directional etching steps, except at the selected locations. By applying directional etch directions along the row and column directions of the array, a pattern of lines and columns is obtained which is otherwise difficult to obtain without applying multiple masks.

The invention is in particular related to a patterning method applicable in a semiconductor production process, the method comprising the steps of :
- on a support substrate, producing a target layer that is to be patterned,
- producing an etch stop layer on the target layer and thereafter a first mask layer on the etch stop layer,
- patterning the first mask layer into a pattern representing a regular 2-dimensional array of openings, or an array obtained by omitting one or more openings from a regular 2-dimensional array,
- applying a first directional etching step that is selective relative to the etch stop layer, wherein the first directional etching step enlarges the openings in a first direction, so that the first mask layer is patterned into an array of parallel line-shaped trenches oriented in the first direction,
- thereafter, producing a second mask layer,
- patterning the second mask layer according to said same pattern representing said array of openings,
- applying a second directional etching step that is selective relative to the etch stop layer, wherein the second directional etching step enlarges the openings in the second mask layer in a second direction that crosses the first direction, so that the second mask layer is patterned into an array of parallel line-shaped trenches oriented in the second direction, and wherein the second directional etching step also removes portions of the patterned first mask layer exposed to etch species applied in the second directional etching step, so that the first mask layer is patterned into a final pattern comprising an array of pillars and/or lines,
- stripping the second mask layer relative to said pillars and/or lines,
- transferring the pattern defined by said pillars and/or lines to the target layer.

According to an embodiment, the patterned first mask layer is thinned after the first directional etching step and prior to the step of producing the second mask layer.

According to an embodiment, the pattern of the patterned first mask layer is transferred to the etch stop layer prior to the step of producing the second mask layer, and the pattern of the patterned second mask layer is transferred to the etch stop layer prior to the step of transferring the pattern defined by said pillars and/or lines to the target layer.

According to an embodiment, the pattern of the patterned first mask layer is not transferred to the etch stop layer prior to the step of producing the second mask layer, and the pattern defined by said pillars and/or lines is transferred to the etch stop layer before transferring said pattern defined by the pillars and/or lines to the target layer.

According to an embodiment :
- the regular array of openings is a rectangular array extending in two perpendicular directions, with one or more openings omitted from the rectangular array,
- the first direction of the first directional etching step is oriented according to one of said perpendicular directions of the array of openings, and
- the second direction of the second directional etching step is oriented according to the other of said perpendicular directions of the array of openings.

According to an embodiment :
- the regular array of openings is a rectangular array extending in two perpendicular directions,
- the first direction of the first directional etching step is oriented between said two orthogonal directions,
- the second direction of the second directional etching step is oriented perpendicularly to the first direction.

According to an embodiment, the first direction is oriented at 45° relative to said two orthogonal directions.

According to an embodiment, the openings are holes having a circular cross-section shape.

According to an embodiment, the first mask layer comprises a stack of sublayers, comprising from bottom to top :
- a first hardmask layer of a thickness t1,
- a second hardmask layer of a thickness higher than t1,
- a third hardmask layer of a thickness essentially equal to t1.
and wherein the third hardmask layer is consumed during the transfer of the pattern of openings from a patterned resist layer formed on the first mask layer to the first mask layer, so that the first directional etching step is performed on a stack formed of the first and second hardmask layers.

According to an embodiment, the second hardmask layer is stripped relative to the first hardmask layer prior to the step of producing the second mask layer.

According to an embodiment, the second mask layer comprises a stack of sublayers, comprising from bottom to top :
- a first hardmask layer of a thickness t1,
- a second hardmask layer of a thickness lower than t1,
and wherein the second hardmask layer is consumed during the transfer of the pattern of openings from a patterned resist layer formed on the second mask layer to the second mask layer.

### Brief description of the figures

Figure 1 illustrates the main components of a tool suitable for directional etching.
Figures 2a and 2b illustrate the process of directional etching.
Figures 3 to 10 illustrate method steps according to a first embodiment of the invention, starting from a rectangular array of openings.
Figures 11a to 11c illustrate that a pattern comprising both pillars and line-shaped features can be obtained by starting from an array of openings wherein a number of openings have been omitted from the full array.
Figures 12 to 18 illustrate a second embodiment of the invention, wherein a pillar array is obtained at a smaller pitch than the array of openings from which the method starts.

### Detailed description of the invention

Basic principles and configurations for realizing directional patterning are for example described in patent publication document US10790155. According to the technology described in the cited document, a plasma beam is scanned relative to a substrate comprising a layer that is to be patterned. By tuning several parameters and conditions, it is possible to direct a plasma beam containing etch species so that the beam etches a layer on the wafer at a considerably higher etch rate in the scanning direction than in directions orthogonal to said scanning direction. This capability makes it possible to 'stretch' an existing opening in the layer by scanning a plasma beam across the opening. The term 'scanning' may imply that the beam moves relative to the patterned layer or vice versa, but also refers within the present context to types of directional etching wherein the beam is stationary but directed according to a given direction to thereby obtain the same elongation effect as a beam that is effectively moving (see further for a more detailed reference to different types of directional etching).

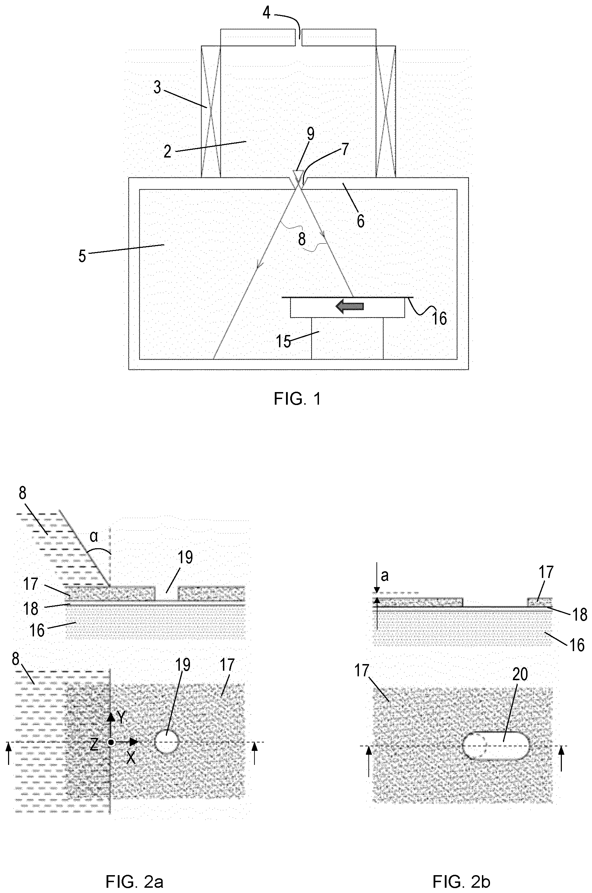

Figure 1 illustrates a process tool 1 for applying one particular directional etching technology that is presently known in the state of the art. The invention is however not limited to this technology. The tool comprises a plasma chamber 2 surrounded by an RF coil 3 for generating a plasma in the chamber. A gas inlet 4 enables supplying a gaseous substance, while the overall pressure in the plasma chamber is kept at very low to vacuum level by a suitable vacuum pump installation (not shown). The plasma chamber 2 is separated from a process chamber 5 by a separating wall 6 comprising a slit 7, so that ribbon plasma beams 8 are emitted from the slit. The process chamber is also at low to vacuum pressure. A meniscus 9 may be mounted in the vicinity of the slit 7 at a distance that can be set in order to control the propagation direction of the emitted beams 8. A wafer stage 15 is mounted in the process chamber 5. The wafer stage 15 is movable linearly as indicated by the arrow, so that a wafer 16 held by the wafer stage can be moved relative to one of the beams 8, thereby creating the equivalent of the beam 8 being scanned across the wafer 16.

As stated, other directional etching technologies are known and can be applied in the method according to the invention. Ion beam-based technologies include a method wherein a collimated beam of charged particles e.g. Ar⁺ is accelerated on a full wafer at a given angle of incidence. In the latter method, the wafer stage is not moving relative to the beam as the beam is impinging on the full wafer. According to another known ion beam-based technology, a collimated beam of ionized gas clusters is accelerated to a spot and scanned across a wafer surface at a given angle of incidence. In the latter two technologies, the angle of incidence of the beam is adjusted by tilting the wafer.

Figures 2a and 2b illustrate the directional etching effect on a layer 17 formed on the wafer 16, by using the tool illustrated in Figure 1. The layer 17 is produced on an etch stop layer 18. Before applying the directional etch process, an opening 19 is formed in the layer 17 by standard lithography and etching, for example by direct ion etching (DIE). A plasma beam 8 is generated and directed at an angle of incidence α, defined as the angle between the beam 8 and the direction perpendicular to the surface of the layer 17. By moving the wafer stage 15 in the direction indicated in Figure 1, the plasma beam 8 is scanned relative to the layer 17 in a scanning direction X. The angle β between the beam 8 and the scanning direction X is an oblique angle equal to 90°+α. By applying a suitable combination of etch parameters such as the RF power, a DC bias voltage connected to the separator plate 6 and/or the wafer stage 15, the applied etch species, the angle of incidence α and the scanning speed, scanning the beam across the opening 19 has the effect of stretching the opening in the scanning direction, as illustrated in Figure 2b. The directional etch process is selective with respect to the etch stop layer 18 so that this layer remains essentially intact and prohibits etching of the underlying support substrate 16. The etch rate in the X-direction is considerably higher than the etch rate in the Y and Z-directions. The result is therefore an elongation of the opening 19 in the X-direction to form a line-shaped trench 20. In the Y-direction the line is slightly larger than the original diameter of the openings, due to the non-zero etch rate in the Y direction. Etching in the Z-direction causes thinning of the layer 17 by a layer thickness reduction a.

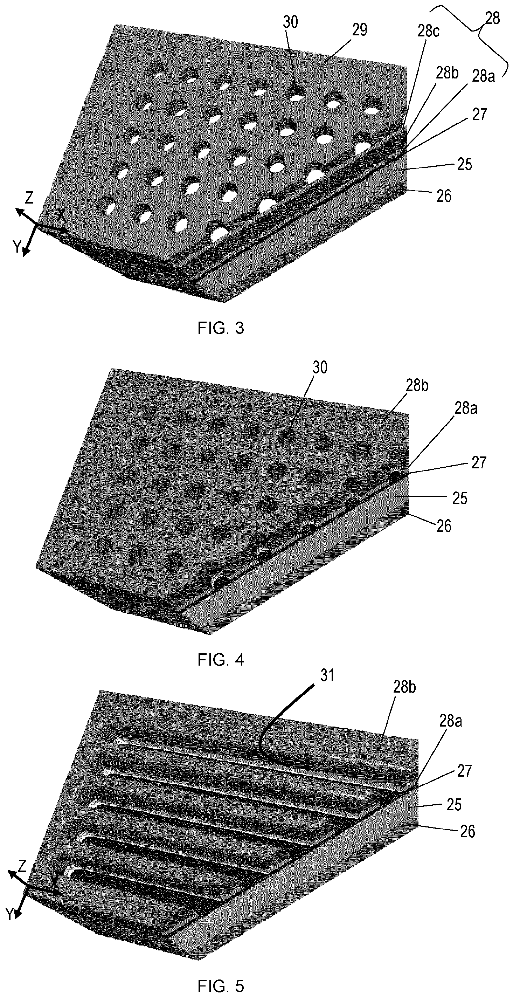

The method according to a first embodiment of the invention is illustrated in Figures 3 to 13. The aim is to pattern a target layer 25 formed on a support substrate 26. The target layer 25 may be any layer that needs to be patterned in the course of a semiconductor fabrication process, for example a dielectric layer formed in the course of the back end of line fabrication of integrated circuits produced on a silicon process wafer, wherein the dielectric layer needs to be patterned by creating pillar-shaped and/or line-shaped features. The invention is however not limited to any type of layer that is be patterned, nor to any particular stage within a semiconductor fabrication process.

With reference to Figure 3 : on top of the target layer 25, an etch stop layer 27 is formed, followed by a mask layer 28 comprising three sublayers : a bottom hardmask layer 28a, a middle hardmask layer 28b and a top hardmask layer 28c. A mask layer is defined within the present context as any layer configured to be patterned into a given pattern whereafter the pattern is transferred to a layer lying underneath the mask layer. Transferring a pattern from a patterned mask layer to an underlying layer is defined within the present context as etching the underlying layer by an etch process that reproduces the mask pattern in the underlying layer.

The stack of hardmask layers 28a-28c is one possible embodiment of a 'mask layer' referred to in the appended claims. A mask layer may have other physical appearances within the wider scope of the invention. It may be a single layer, for example a layer of photoresist. The three-sublayer stack 28a-28c may be used to produce very small features, having dimensions in the order of nanometers. The invention is however not limited to any particular dimensions of the patterned features produced by the method of the invention.

The material of the etch stop layer 27 may depend on the hard mask stack material combination but can be a metal-based material (for example Ti, TiN, TiO₂, TiON, Ta, TaN...), an aluminium-based dielectric material, or a Si-based material like amorphous Si. The material of the bottom hardmask layer 28a depends on the hard mask stack material combination but can be a dielectric material used in semiconductor fabrication like Spin on glass, SiOC, SiO₂, SiN, SiON, SiCN, SiOCN, SiC, or a metal-based material (for example Ti, TiN, TiO₂, TiON, Ta, TaN...) or an aluminium-based dielectric material. The middle hardmask layer 28b can for example be an organic carbon-containing layer like amorphous carbon, Diamond like Carbon (DLC) or Spin on Carbon (SOC). The top hardmask layer 28c can be formed of the same material as the bottom layer 28a or formed of one of the materials cited as possible materials for the bottom layer. The thickness of the top and bottom layers 28a,28c is preferably the same and smaller than the thickness of the middle layer 28b. In the particular nonlimiting embodiment illustrated in the drawings, the thickness of the top and bottom hardmask layers 28a,28c may be in the order of 10-15nm while the thickness of the middle layer 28b may be in the order of 50-100 nm.

On top of the mask layer 28, a resist layer 29 is formed and patterned by standard lithography into a pattern of openings 30. The pattern is a regular array of circular openings 30 of equal diameter, but other shapes of the cross-section of the openings are possible as well. In the case shown, the pattern is a square pattern, i.e. the openings are arranged in orthogonally arranged rows and columns, with constant spacings between openings in the two directions. The diameter of the openings 30 may be in the order of 20 nm. Other array configurations are equally possible, for example a hexagonal array of openings.

With reference to Figure 4, the pattern of openings 30 is transferred to the mask layer 28. This may be done by first etching the top mask layer 28c relative to the resist 29 using a first etch recipe. Then the middle hardmask layer 28b is etched using a second etch recipe that also etches the resist 29. The resist is therefore consumed as the openings are etched in the middle hardmask layer 28b. Then the bottom hardmask layer 28a is etched by a third etch recipe, while simultaneously the top hardmask layer 28c is consumed. The result is shown in Figure 4 : the pattern of openings 30 has been transferred to the bottom hardmask layer 28a and the middle hardmask layer 28b, i.e. openings 30 having upright sidewalls are formed through the layer 28a+28b. The term 'upright sidewalls' refers to sidewalls which are perpendicular to the plane of the support substrate 26 or close to perpendicular, i.e. a small deviation from the geometrical perpendicular orientation is included in the term 'upright'.

At this point, the hardmask layers 28a and 28b are subjected to a directional etch step as described above, and as illustrated in Figure 5. A directional etch beam is scanned in a direction parallel to the X-axis of the illustrated orthogonal axis system XYZ, across the pattern of openings, thereby etching layers 28a and 28b selectively with respect to the etch stop layer 27.

The directional etch process elongates the openings 30 by removing material of layers 28a and 28b, to the extent that the openings merge into continuous trenches 31 oriented in the X-direction, as illustrated in Figure 5. This could require multiple scannings of the beam in the +X and/or the -X direction. The hardmask layer 28b is thinned as a consequence of a given vertical etch rate, as described above. The width of the trenches may be a little higher than the original diameter of the openings, due to a small etch rate in the Y-direction.

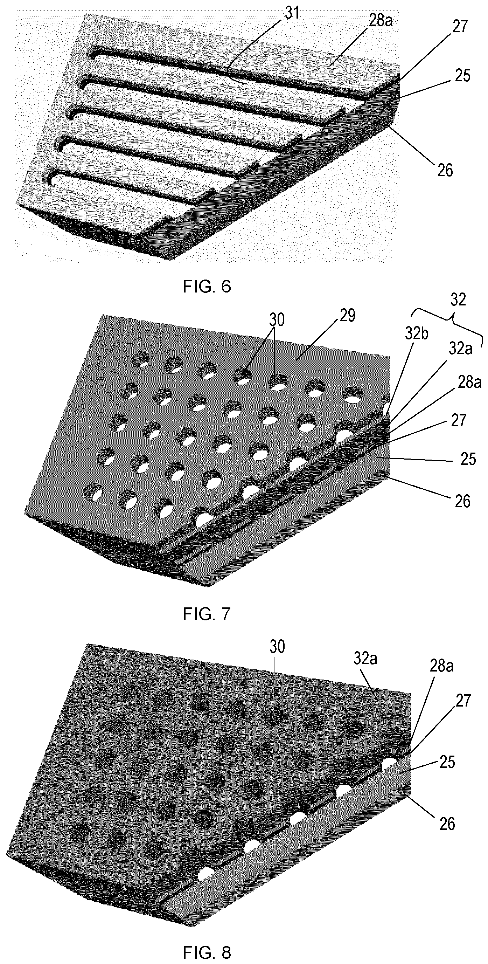

With reference to Figure 6, the pattern of trenches 31 is transferred to the underlying etch stop layer 27, followed by stripping of the middle hardmask layer 28b selectively with respect to the bottom hardmask layer 28a. The target layer 25 is now exposed at the bottom of the transferred trenches 31.

Then, with reference to Figure 7, a second mask layer 32 is produced, comprising a first hardmask layer 32a and a second hardmask layer 32b.

Layer 32a may be formed of the same material and have the same thickness as the middle hardmask layer 28b of the first mask layer 28, while layer 32b may be formed of the same material and have the same thickness as the top hardmask layer 28c of the first mask layer 28. A resist layer 29 is again formed on the second mask layer 32 and patterned into the same square pattern of openings 30, the openings being placed at the same locations and having the same diameter as the openings of the first array.

With reference to Figure 8, the second square pattern is transferred to the second mask layer 32 in the same way as was described in relation to the first mask layer 28, so that the bottom of the first trenches 31 is exposed at the bottom of the transferred openings 30 through the hardmask layer 32a.

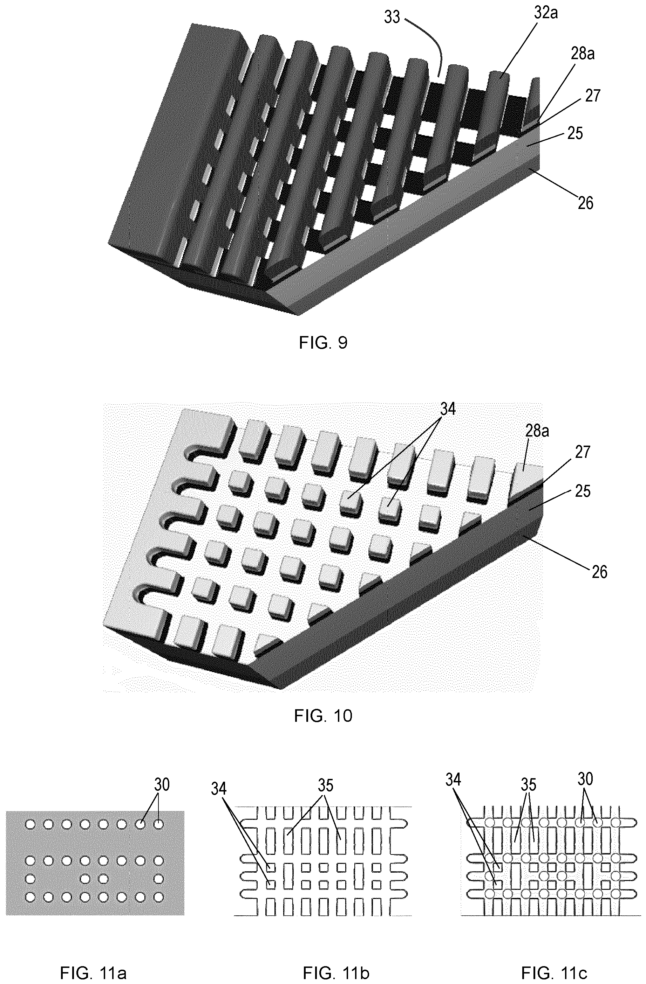

With reference to Figure 9, a second directional etch process is now applied, by scanning an etch beam in the +Y or -Y direction, or by repeated scannings in said +Y and/or -Y direction. The second directional etch step enlarges the openings 30, by removing material of the hardmask layer 32a. However, at the bottom end of the sidewalls of the openings 30, parallel strips of the bottom hardmask layer 28a have remained after the first directional etch step, hence regularly spaced portions of these strips are also exposed to the etch beam (i.e. to etch species contained in said etch beam) in the second directional etching step and said portions are removed by said beam relative to the material of the etch stop layer 27. The second directional etch process is applied until the openings 30 merge into second trenches 33 oriented perpendicularly with respect to the first trenches 31. At the bottom of the second trenches 33, regularly spaced portions of the etch stop layer 27 remain.

The pattern of the second trenches 33 is then transferred to the etch stop layer 27, and the hardmask layer 32a is stripped selectively with respect to the hardmask layer 28a, leaving a grid of pillars 34 on the target layer 25 as illustrated in Figure 10. This grid of pillars can thereafter be transferred to the target layer 25 by a suitable etch process that etches the target layer selectively with respect to the pillars 34. The materials of the mask layers 28 and 32 are chosen so that the above sequence of steps is enabled. This requires for example that layer 32a can be removed selectively with respect to the hardmask layer 28a and with respect to the target layer 25.

According to an alternative embodiment, the pattern of the first trenches 31 is not transferred to the etch stop layer 27 prior to applying the second directional etch process, i.e. the bottom of the transferred trenches 31 is formed by the etch stop layer 27. The etch stop layer 27 is then still present at the bottom of the openings 30 formed through the hardmask layer 32a, and the obtained grid of pillars 34 is transferred to the etch stop layer 27 and to the target layer 25 in consecutive etch steps.

When the array of openings 30 is a square or rectangular array as described above, the resulting array of the pillars 34 is also a square or rectangular array having the same center-to-center pitch as the original array.

According to other embodiments, the same methodology is applied to a square or rectangular array of openings wherein one or more openings are omitted from the array. An example thereof is shown in Figures 11a to 11c. Figure 11a shows the original array of openings 30. Figure 11b shows the resulting array which now comprises pillars 34 as well as line-shaped features 35. Figure 11c shows a superposition of the original openings 30 and the obtained array of pillars and lines. By selecting the location of omitted openings from the array, various arrays of pillars and line-shaped features can be produced. The invention thereby provides an alternative to existing patterning methods applicable for producing such patterns and which include the application of multiple lithographic masks, whereas the present invention enables to obtain such patterns using a single lithographic mask for producing a given array of openings 30.

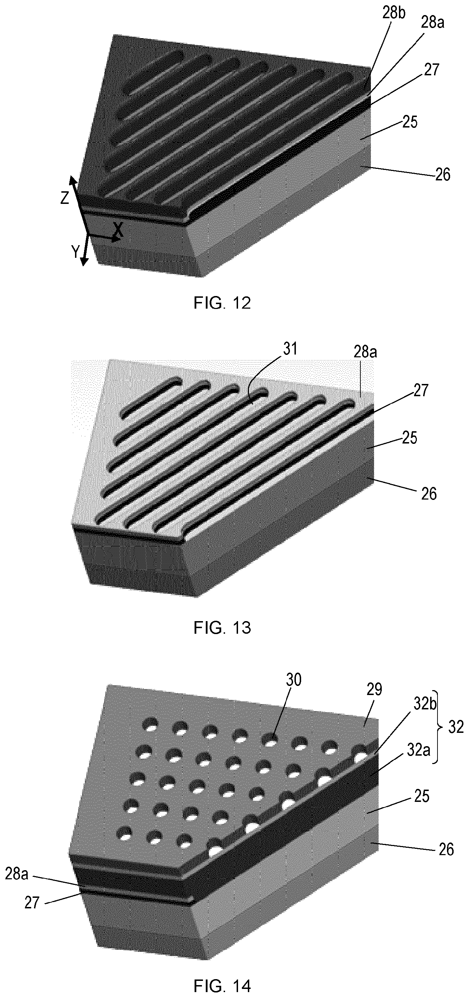

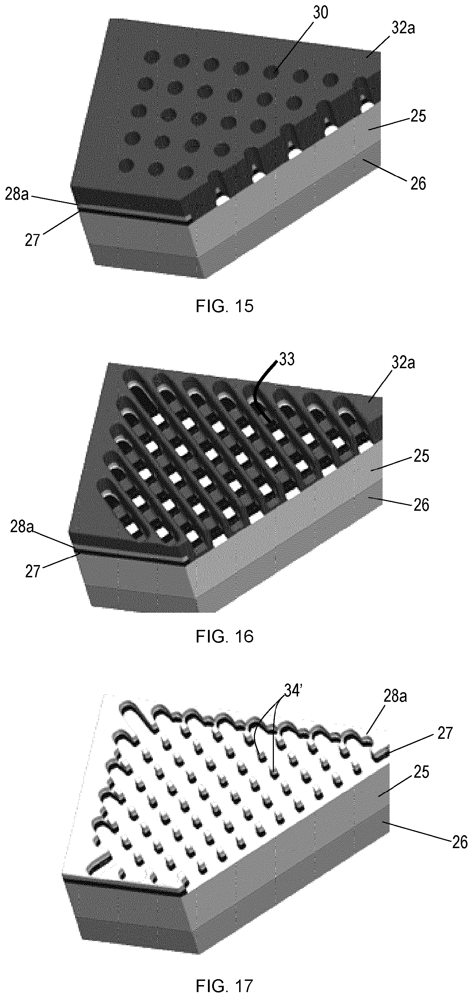

A further embodiment is illustrated in Figures 12 to 18. The same mask layers and method steps are applied as described in relation to the first embodiment, however the scanning directions of the two directional etching steps are different. The steps described with reference to Figures 3 and 4 are therefore equally applicable for this embodiment. However, the first directional etching step is now performed in a scanning direction that is oriented at 45° with respect to the X direction, as illustrated in Figure 12. Scanning can be repeated several times in the same or in the opposite direction. The first trenches 31 are now formed by merging openings 30 in the direction of the diagonals of the square pattern. This means that the trenches 31 are closer together compared to the first embodiment. After the first directional etch step, the hardmask layer 28b is stripped (Figure 13) and the second mask layer 32 is produced in the same way as in the first embodiment, as seen in Figure 14. The square pattern of openings 30 is again formed in a resist layer 29 and transferred to the second mask layer, as illustrated in Figure 15.

With reference to Figure 16, the second directional etching step is then applied along a scanning direction perpendicular to the scanning direction of the first directional etching step, i.e. at 135° with respect to the X-direction. Scanning can again be repeated several times in the same or in opposite directions. The second directional etching step is applied until second trenches 33 are formed oriented perpendicularly to the first trenches 31.

After stripping of the hardmask layer 32a, a grid of pillars 34' is obtained as shown in Figure 17, which can be transferred to the target layer 25.

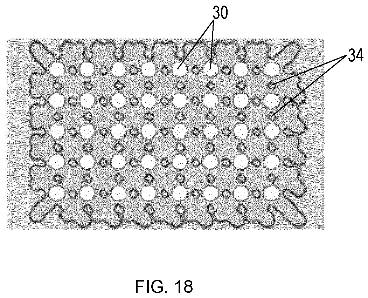

As illustrated in the superposed image in Figure 18, the center-to-center pitch of the pillar grid is smaller than the pitch of the original pattern of openings 30. This embodiment is advantageous therefore through the fact that an array can be produced at smaller pitch than the pitch of the initial array of openings 30. By starting from an array of openings 30 that is close to the smallest pitch obtainable by standard lithography and etching, the invention thereby enables producing an array of features at subresolution pitch.

The orientation of the scanning directions of the two directional etching steps is not limited to the above-described cases. For example, in the case of the rectangular array of openings 30 (with or without omission of selected openings) represented in the drawings, the scanning direction of the first step may be anywhere between the two orthogonal directions defined by the rows and columns of the array of openings 30. The scanning direction of the second directional etch step is preferably perpendicular to the first scanning direction, but other orientations are not excluded.

The array of openings 30 (with or without omissions) could be arranged according to another pattern instead of the rectangular pattern illustrated in the drawings, for example a hexagonal pattern, which enables producing further variants of the resulting pillar and/or line patterns. All realistically applicable combinations of arrays of openings 30 and scanning directions of the first and second directional etching steps are included in the scope of the present invention.

The step of transferring the pattern of pillars 34,34' and/or lines 35 includes embodiments wherein a tone reversal is performed before actually transferring the pattern, i.e. positive features (pillars and/or lines) are transformed to negative features (holes and/or trenches). This may be done by depositing a layer that fills the spaces between the pillars and/or lines, planarizing said layer and selectively removing the pillars and/or lines with respect to said layer, to obtain holes and/or trenches. These holes and/or trenches are then transferred to the target layer 25.

The array of openings 30 applied in the method is a regular array of openings, i.e. an array of openings having the same in-plane dimensions (for example circular holes as in the illustrated embodiments) and arranged according to a repetitive pattern like the square array illustrated in the drawings. Other regular arrays can be used, for example a hexagonal array wherein each opening is surrounded by six other openings at angular spacings of 60°. Such an array comprises rows and columns which are not perpendicular but which are at an angle different from 90°. The etching directions of the directional etching steps applied in the method can be adapted to these directions, in order to obtain analogue results as described above for the embodiments based on perpendicular rows and columns.

## Claims

1. A patterning method applicable in a semiconductor production process, the method comprising the steps of :
- on a support substrate (26), producing a target layer (25) that is to be patterned,
- producing an etch stop layer (27) on the target layer and thereafter a first mask layer (28) on the etch stop layer,
- patterning the first mask layer (28) into a pattern representing a regular 2-dimensional array of openings (30), or an array obtained by omitting one or more openings from a regular 2-dimensional array,
- applying a first directional etching step that is selective relative to the etch stop layer (27), wherein the first directional etching step enlarges the openings (30) in a first direction, so that the first mask layer is patterned into an array of parallel line-shaped trenches (31) oriented in the first direction,
- thereafter, producing a second mask layer (32),
- patterning the second mask layer according to said same pattern representing said array of openings (30),
- applying a second directional etching step that is selective relative to the etch stop layer (27), wherein the second directional etching step enlarges the openings (30) in the second mask layer (32) in a second direction that crosses the first direction, so that the second mask layer (32) is patterned into an array of parallel line-shaped trenches (33) oriented in the second direction, and wherein the second directional etching step also removes portions of the patterned first mask layer (28) exposed to etch species applied in the second directional etching step, so that the first mask layer (28) is patterned into a final pattern comprising an array of pillars (34) and/or lines (35),
- stripping the second mask layer (32) relative to said pillars and/or lines,
- transferring the pattern defined by said pillars and/or lines to the target layer (25).

2. The method according to claim 1, wherein the patterned first mask layer (28) is thinned after the first directional etching step and prior to the step of producing the second mask layer (32).

3. The method according to claim 1 or 2, wherein the pattern of the patterned first mask layer (28) is transferred to the etch stop layer (27) prior to the step of producing the second mask layer (32), and wherein the pattern of the patterned second mask layer (32) is transferred to the etch stop layer (27) prior to the step of transferring the pattern defined by said pillars and/or lines to the target layer (25).

4. The method according to claim 1 or 2, wherein the pattern of the patterned first mask layer (28) is not transferred to the etch stop layer (27) prior to the step of producing the second mask layer (32), and wherein the pattern defined by said pillars and/or lines is transferred to the etch stop layer (27) before transferring said pattern defined by the pillars and/or lines to the target layer (25).

5. The method according to any one of the preceding claims, wherein :
- the regular array of openings (30) is a rectangular array extending in two perpendicular directions, with one or more openings omitted from the rectangular array,
- the first direction of the first directional etching step is oriented according to one of said perpendicular directions of the array of openings, and
- the second direction of the second directional etching step is oriented according to the other of said perpendicular directions of the array of openings.

6. The method according to any one of claims 1 to 4, wherein :
- the regular array of openings (30) is a rectangular array extending in two perpendicular directions,
- the first direction of the first directional etching step is oriented between said two orthogonal directions,
- the second direction of the second directional etching step is oriented perpendicularly to the first direction.

7. The method according to claim 6, wherein the first direction is oriented at 45° relative to said two orthogonal directions.

8. The method according to any one of the preceding claims, wherein the openings (30) are holes having a circular cross-section shape.

9. The method according to any one of the preceding claims, wherein the first mask layer (28) comprises a stack of sublayers, comprising from bottom to top :
- a first hardmask layer (28a) of a thickness t1,
- a second hardmask layer (28b) of a thickness higher than t1,
- a third hardmask layer (28c) of a thickness essentially equal to t1.
and wherein the third hardmask layer (28c) is consumed during the transfer of the pattern of openings (30) from a patterned resist layer (29) formed on the first mask layer to the first mask layer, so that the first directional etching step is performed on a stack formed of the first and second hardmask layers (28a,28b).

10. The method according to claim 9, wherein the second hardmask layer (28b) is stripped relative to the first hardmask layer (28a) prior to the step of producing the second mask layer (32).

11. The method according to any one of the preceding claims, wherein the second mask layer (32) comprises a stack of sublayers, comprising from bottom to top :
- a first hardmask layer (32a) of a thickness t1,
- a second hardmask layer (32b) of a thickness lower than t1,
and wherein the second hardmask layer (32b) is consumed during the transfer of the pattern of openings (30) from a patterned resist layer (29) formed on the second mask layer to the second mask layer.
